# EUROPEAN PATENT APPLICATION

(11) **EP 4 660 655 A1**
(43) Date of publication of application: **10.12.2025**
(21) Application number: 25181143.6
(22) Date of filing: 05.06.2025
(51) Int. Cl.: G01R 33/36

(54) **OPTICAL WIRELESS UNIT AND MAGNETIC RESONANCE IMAGING APPARATUS**

(30) Priority: 07.06.2024 JP 2024092780
(71) Applicant: FUJIFILM Corporation, Tokyo 106-8620 (JP)
(72) Inventor: ISHII, Koki, Tokyo, 1068620 (JP); OTA, Atsushi, Tokyo, 1068620 (JP); CHUMAN, Takashi, Tokyo, 1068620 (JP)
(74) Representative: Dehns Germany Partnerschaft mbB

(57) **Abstract**

Provided are a cableless optical wireless unit that can avoid electromagnetic wave interference and has good usability, and a magnetic resonance imaging apparatus including the same. An optical wireless unit that is connected to a receive coil unit (200) including a plurality of coil elements (200-j) via a connector (14), the optical wireless unit including: a cableless housing (12), in which the housing includes a battery (16) that supplies electricity to the receive coil unit, and an optical transceiver (114) that converts signal data received from the receive coil unit into an optical wireless signal and transmits the optical wireless signal, and that receives and converts a control signal transmitted by the optical wireless transmission into an electrical signal.

## Description

### BACKGROUND OF THE INVENTION

### 1. Field of the Invention

The present disclosure relates to an optical wireless unit and a magnetic resonance imaging (MRI) apparatus.

### 2. Description of the Related Art

In the MRI apparatus, a subject placed in a static magnetic field is irradiated with high-frequency electromagnetic waves to excite nuclear spins in the subject, such as nuclear spins of hydrogen atoms, and a nuclear magnetic resonance (NMR) signal generated in a case in which the excited nuclear spins return to an equilibrium state is detected and subjected to signal processing, thereby creating an image of a hydrogen nuclei distribution in a living body.

JP2014-46094A discloses a digital wireless communication device comprising a connection portion that is attachably and detachably connected to a receive coil unit which detects a nuclear magnetic resonance signal emitted from a subject at a time of execution of magnetic resonance imaging, and a wireless communication unit that acquires the nuclear magnetic resonance signal detected by the receive coil unit via the connection portion, digitizes the nuclear magnetic resonance signal, and wirelessly transmits the digitized nuclear magnetic resonance signal.

JP2015-123108A discloses a magnetic resonance imaging apparatus comprising a receive coil unit that receives a magnetic resonance signal radiated from a subject, a bed provided with a coil port connected to the receive coil unit, a conversion unit that is provided at the coil port and generates magnetic resonance signal data by converting all the magnetic resonance signals output from the receive coil unit into digital signals, a selection unit that selects magnetic resonance signal data used for reconstruction from the magnetic resonance signal data, and a reconstruction unit that reconstructs image data by using the magnetic resonance signal data selected by the selection unit. In addition, a raw data transmission unit connected to the coil port comprises a parallel to serial (P/S) conversion unit and an electrical to optical (E/O) conversion unit, and is configured to transmit the magnetic resonance signal data converted into a serial signal to a raw data reception unit via an optical cable after E/O conversion.

JP2007-144192A proposes a magnetic resonance imaging system comprising a plurality of coil elements configured to supply each coil output signal based on a plurality of magnetic resonance response signals detected by the coil elements, and an optical link coupled to the plurality of coil elements to transmit at least one optical beam configured to transmit receive coil signal information through the air.

### SUMMARY OF THE INVENTION

In the related art, a weak nuclear magnetic resonance signal acquired by a receive coil unit is transmitted by an electric cable and digitized at a position away from a gantry. On the other hand, since digitization of a signal immediately before the receive coil unit is effective in order to prevent noise from being mixed or lost, a configuration has been proposed in which a connector connected to an analog to digital (A/D) converter of a coil port provided on a top plate of a bed in a manner that the connector is connectable to the receive coil unit is prepared, and the digital wireless transmission of the NMR signal is realized by using the existing receive coil unit as it is, and replacement of the receive coil unit is not required (JP2014-46094A and JP2015-123108A).

However, in the configuration of JP2014-46094A, since the communication method is wireless communication using radio waves, communication stability in the use environment of the MRI apparatus is a problem. In addition, in the configuration of JP2014-46094A, since the handling of the receive coil unit is limited by the cable connection from the receive coil unit to the coil port, there is a demand for improvement in usability from the medical field.

As proposed in JP2007-144192A, electromagnetic wave interference and an increase in cost in an MRI environment can be avoided by applying optical wireless communication, but JP2007-144192A does not disclose a specific mounting method.

The present disclosure has been made in view of such circumstances, and an object of the present disclosure is to provide a cableless optical wireless unit that can avoid electromagnetic wave interference and has good usability. In addition, another object of the present disclosure is to provide a magnetic resonance imaging apparatus including the optical wireless unit.

According to a first aspect of the present disclosure, there is provided an optical wireless unit that is connected to a receive coil unit including a plurality of coil elements via a connector, the optical wireless unit comprising: a cableless housing, in which the housing includes a battery that supplies electricity to the receive coil unit, and an optical transceiver that converts signal data received from the receive coil unit into an optical wireless signal and transmits the optical wireless signal, and that receives and converts a control signal transmitted by the optical wireless transmission into an electrical signal.

In the optical wireless unit according to the first aspect, the cableless optical wireless unit can be connected to the connector of the receive coil unit. Therefore, it is not necessary to handle a complicated physical cable, and the workability of connecting the receive coil unit in a medical field is improved. In addition, according to the first aspect, since the signal data obtained from the receive coil unit is converted into the optical wireless signal and transmitted, it is possible to transmit the signal data while avoiding electromagnetic wave interference. The term "optical wireless unit" is synonymous with "optical wireless module".

According to a second aspect, in the optical wireless unit according to the first aspect, the connector provided in the receive coil unit may be a first connector to which a physical cable is connectable, and the housing may include a second connector that is connectable to the first connector provided in the receive coil unit.

According to the second aspect, the physical cable or the optical wireless unit can be selectively connected to the connector (first connector) of the receive coil unit.

According to a third aspect, in the optical wireless unit according to the first aspect or the second aspect, it is preferable that the housing is a shield housing.

In the optical wireless unit according to a fourth aspect, in the optical wireless unit according to the third aspect, the housing may be configured using a substrate material including a layer of a metal material.

According to a fifth aspect, in the optical wireless unit according to the fourth aspect, the substrate material may be a double-sided substrate material in which the layer of the metal material is laminated on both surfaces of a low-conductivity material.

The term "low-conductivity material" includes the concept of an insulating material.

According to a sixth aspect, in the optical wireless unit according to any one of the third aspect to the fifth aspect, the housing may include a slit that compartmentalizes a metal material forming the housing, and an area of a continuous conductor region of the metal material compartmentalized by the slit may be limited.

By limiting the area of the region (the area of the continuous conductor region) per compartment of the metal material compartmentalized by the slit, the generation of eddy current can be suppressed.

According to a seventh aspect, in the optical wireless unit according to the sixth aspect, the metal material forming the housing may include a first metal layer and a second metal layer that are laminated with a low-conductivity material interposed therebetween, the first metal layer and the second metal layer each may include the slit, and in a case where the metal material is viewed in a plan view, positions of the slits in a first direction provided in each of the first metal layer and the second metal layer may be relatively shifted in a second direction different from the first direction.

According to the housing in the seventh aspect, it is possible to increase the shielding effect while suppressing the generation of eddy current.

According to an eighth aspect, in the optical wireless unit according to any one of the first to seventh aspects, in which the housing may further include a memory that temporarily stores the signal data.

According to the eighth aspect, in a case where a temporary communication failure occurs in the optical wireless communication, the signal data to be transmitted can be stored in the memory, and the signal data in the memory can be transmitted after the communication is reestablished.

According to a ninth aspect, in the optical wireless unit according to any one of the first to eighth aspects, in which the housing may further include an A/D converter that converts an analog signal received from the receive coil unit into a digital signal.

According to a tenth aspect, in the optical wireless unit according to the ninth aspect, in which the housing may further include a digital processing circuit that processes the digital signal.

According to an eleventh aspect, in the optical wireless unit according to the tenth aspect may be configured such that in the optical wireless unit according to the tenth aspect, the digital processing circuit includes a decimator that thins out data of the digital signal.

According to a twelfth aspect, in the optical wireless unit according to the tenth or eleventh aspect, the digital processing circuit may include a circuit that serializes the signal data obtained from each of the plurality of coil elements for optical wireless transmission.

According to a thirteenth aspect, in the optical wireless unit according to the twelfth aspect, the circuit to be serialized may include a multiplexer and a circuit for encoding.

According to a fourteenth aspect, in the optical wireless unit according to any one of the first to thirteenth aspects, the housing may further include a circuit that deserializes the control signal.

According to a fifteenth aspect, in the optical wireless unit according to any one of the first to fourteenth aspects, in which the control signal may include at least one of a sampling clock of an A/D converter disposed in the housing, a control signal for setting an operation of the A/D converter, a control signal for setting digital signal processing, a control signal for setting a gain of a variable gain amplifier, or a decoupler signal of the receive coil unit.

According to a sixteenth aspect, in the optical wireless unit according to any one of the first to fifteenth aspects, in which the housing may further include a charging port for charging the battery.

According to a seventeenth aspect of the present disclosure, there is provided a magnetic resonance imaging apparatus comprising: a receive coil unit that includes a plurality of coil elements and includes a connector to which a physical cable for transmitting a nuclear magnetic resonance signal obtained from the plurality of coil elements is connectable; a first optical wireless unit that is connected to the receive coil unit via the connector; a second optical wireless unit that performs optical wireless communication with the first optical wireless unit; and an image reconstruction unit that reconstructs an image on the basis of data of the nuclear magnetic resonance signal acquired via the second optical wireless unit, in which the first optical wireless unit includes a cableless housing, and the housing includes a battery that supplies electricity to the receive coil unit, and an optical transceiver that converts signal data received from the receive coil unit into an optical wireless signal and transmits the optical wireless signal, and that receives and converts a control signal transmitted by the optical wireless transmission into an electrical signal.

The same configuration as the optical wireless unit according to any one of the second to sixteenth aspects can be applied to the first optical wireless unit in the magnetic resonance imaging apparatus according to the seventeenth aspect.

According to the present invention, it is possible to provide a cableless optical wireless unit that can be connected to a receive coil unit via a connector and can transmit signal data while avoiding electromagnetic wave interference. As a result, it is not necessary to perform work such as complicated cable connection, which contributes to improvement in workability. In addition, with the magnetic resonance imaging apparatus comprising the optical wireless unit, it is possible to suppress the influence of the noise component, and it is possible to obtain a good image.

### BRIEF DESCRIPTION OF THE DRAWINGS

Fig. 1 is a perspective view showing an appearance of an exemplary magnetic resonance imaging (MRI) apparatus.
Fig. 2 is a schematic diagram showing an internal configuration of an MRI apparatus.
Fig. 3 is an overview diagram showing a configuration example of a receive coil unit.
Fig. 4 is an explanatory diagram showing an application example of the optical wireless unit according to the embodiment.
Fig. 5 is a block diagram showing an example of a functional configuration of an optical wireless unit.
Fig. 6 is an explanatory diagram schematically showing a configuration of an MRI apparatus using an optical wireless unit.
Fig. 7 is an explanatory diagram of a case where a control signal is transmitted from a control unit to an optical wireless unit.
Fig. 8 is an explanatory diagram showing a specific example of a signal received by the optical wireless unit through optical wireless communication.
Fig. 9 is a cross-sectional view showing an example of a substrate material used in a housing of the optical wireless unit.
Fig. 10 is a perspective view showing an example of a housing configured using the substrate material shown in Fig. 9.
Fig. 11 is a diagram showing an example of a case where the optical wireless unit and the receive coil unit are connected to each other by using a flexible cable.

### DESCRIPTION OF THE PREFERRED EMBODIMENTS

Hereinafter, preferable embodiments of the present invention will be described in detail with reference to the accompanying drawings. In the following description and the accompanying drawings, components having the same functional configuration will be denoted by the same reference numerals, and duplicated descriptions will not be repeated.

### Overview of Magnetic Resonance Imaging (MRI) Apparatus

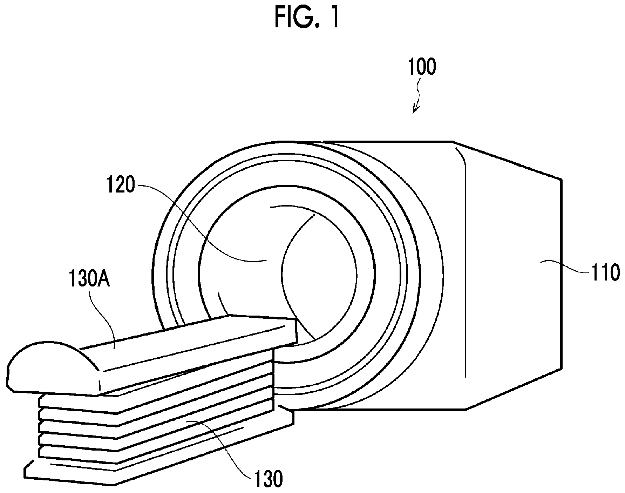

Fig. 1 is a perspective view showing an appearance of an exemplary MRI apparatus 100. The MRI apparatus 100 comprises a gantry 110 which is an apparatus main body, and a bed 130. The bed 130 comprises a top plate 130A and is disposed on a front side of a bore 120, which is a cylindrical imaging space provided in the gantry 110. The top plate 130A can enter the bore 120 and exit from the bore 120 by a top plate drive mechanism (not shown) provided in the bed 130. The bed 130 may be configured to be fixed to the gantry 110 or may be a mobile bed (dockable bed) that is attachable to and detachable from the gantry 110.

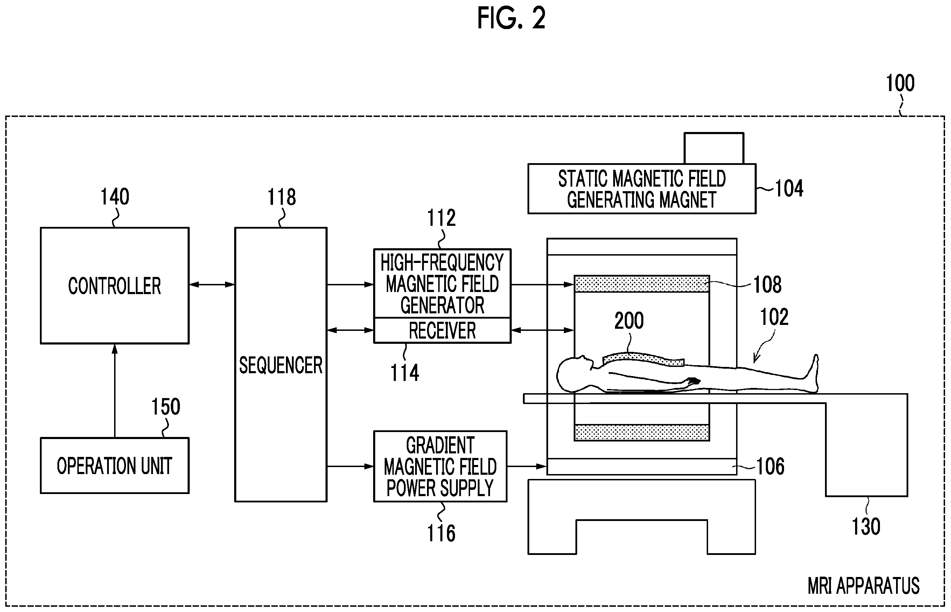

Fig. 2 is a diagram showing a schematic configuration of the inside of the MRI apparatus 100. The MRI apparatus 100 comprises a static magnetic field generating magnet 104, an gradient magnetic field coil 106, an RF (radio frequency) transmission coil 108, and a receive coil unit 200. The subject 102 is placed on a top plate 130A of the bed 130 and is disposed in the imaging space. That is, the top plate 130A on which the subject 102 is placed is moved to the bore 120, so that the examination site of the subject 102 is moved to be located at the center of the static magnetic field in the bore 120.

The static magnetic field generating magnet 104 generates a uniform static magnetic field in the imaging space. The static magnetic field generating magnet 104 includes a static magnetic field generating source of a permanent magnet type, a normal conducting type, or a superconducting type. The gradient magnetic field coil 106 generates a gradient magnetic field in the imaging space. The gradient magnetic field coil 106 is composed of gradient magnetic field coils in three-axis directions of X, Y, and Z, which are real space coordinate systems (stationary coordinate systems). Each gradient magnetic field coil is connected to the gradient magnetic field power supply 116 and is supplied with a current. As a result, the gradient magnetic fields are generated in three-axis directions of X, Y, and Z.

The RF transmission coil 108 is a coil that irradiates the subject 102 with a radio frequency magnetic field pulse (RF pulse). The RF transmission coil 108 is connected to the high-frequency magnetic field generator 112, and is supplied with a high-frequency pulse current. The high-frequency magnetic field generator 112 is driven in response to a command from the sequencer 118 to amplitude-modulate the high-frequency pulse and supplies the amplified high-frequency pulse to the RF transmission coil 108.

The sequencer 118 sends commands to the high-frequency magnetic field generator 112 and the gradient magnetic field power supply 116 in accordance with the imaging pulse sequence to generate the high-frequency magnetic field and the gradient magnetic field, respectively. The generated high-frequency magnetic field is applied to the subject 102 as a pulsed high-frequency magnetic field (RF pulse) via the RF transmission coil 108. Consequently, a nuclear magnetic resonance (NMR) phenomenon is induced in the spins of the atoms constituting the biological tissue of the subject 102.

The receive coil unit 200 is a coil that receives an echo signal (referred to as an NMR signal) released by the NMR phenomenon of the spins of an atom constituting a biological tissue of the subject 102. In Fig. 2, an example of the blanket type receive coil unit 200 applied to imaging of the chest and the abdomen is illustrated, but a form of the receive coil unit may be applied differently depending on the examination site. For example, a receive coil unit for imaging various parts, such as a head, a spine, an abdomen, a leg, and an arm, can be used. The number of receive coil units used in one imaging may be one or plural, and a plurality of receive coil units for imaging different parts may be used simultaneously. The receive coil unit may be simply referred to as a receive coil. The NMR signal generated from the subject 102 is received by the receive coil unit 200, and is subjected to A/D conversion by a receiver 114.

The sequencer 118 controls each unit to operate at a timing and intensity programmed in advance. Among the programs, a program that particularly describes the RF pulse, the gradient magnetic field, and the timing or the intensity of the signal reception is called the pulse sequence. Various pulse sequences depending on the purpose are known, but the detailed description thereof will be omitted here.

A controller 140 controls an operation of the MRI apparatus 100 via the sequencer 118, and receives the signal from the receiver 114 and performs various types of signal processing, such as image reconstruction. The receiver 114 converts the signal obtained from the receive coil unit 200 into the raw data and then transmits the raw data to the controller 140. The raw data is also referred to as an echo signal or measurement data.

The controller 140 can be configured by using a computer. The computer applied to the controller 140 may be a personal computer or a workstation.

The controller 140 receives various instruction inputs from an operation unit 150, collectively controls the respective units of the MRI apparatus 100, and performs processing of converting the echo signal in a spatial frequency domain received via the sequencer 118 into an image in the real space by performing inverse Fourier transformation, and the like to generate an MRI image.

The operation unit 150 includes a mouse, a keyboard, and the like, and functions as a part of a graphical user interface (GUI) that receives an input from an operator by using a display operation window of a display (not shown). That is, the operation unit 150 and the display function as the GUI for the operator to input the activation, the stop (temporary stop), the pulse sequence selection, the imaging conditions, the processing conditions, and the like of the MRI apparatus 100.

### Overview of Receive coil Unit

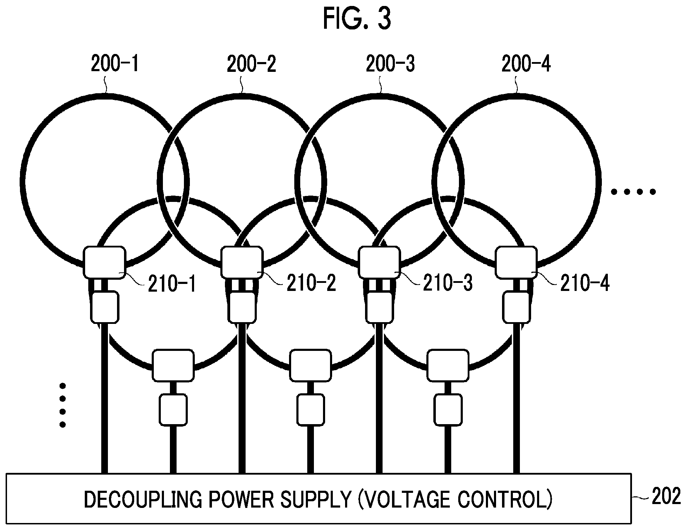

Fig. 3 is an overview diagram showing a configuration example of the receive coil unit 200. The receive coil unit 200 may be, for example, a flexible, thin, and lightweight coil unit that can cover a wide imaging range of the chest and abdomen of the subject 102. The receive coil unit 200 is an array coil in which multi-channelization is achieved. In the receive coil unit 200, a plurality of loop-shaped coil elements 200-1, 200-2, 200-3, 200-4, ..., and 200-n that function as antennas receiving the NMR signal are arranged in a two-dimensional array, and decoupling circuits 210-1, 210-2, 210-3, 210-4, ..., and 210-n are provided corresponding to the respective coil elements 200-j (j = 1, 2, 3, 4, ..., and n).

Each of the plurality of coil elements 200-j functions as an antenna that receives the NMR signal generated from the biological tissue of the subject 102. Each coil element 200-j is adjusted to resonate at a specific frequency. The specific frequency is decided by an atomic nucleus (usually, a hydrogen nucleus) to be observed in the biological tissue, and a magnetic field intensity.

The shape, the number (the number of channels), and the arrangement form of the coil element 200-j are not limited to the example shown in Fig. 3. In a case of a receive coil unit for an abdomen, the number of coil elements 200-j may be, for example, in a range of 16 to 128.

The plurality of decoupling circuits 210-j (j = 1, 2, 3, 4, ..., n) include a voltage-driven field effect transistor (FET), and the FET in each decoupling circuit is ON/OFF-controlled by a drive voltage supplied from a decoupling power supply 202.

### Description of Configuration of Optical Wireless Unit According to Embodiment

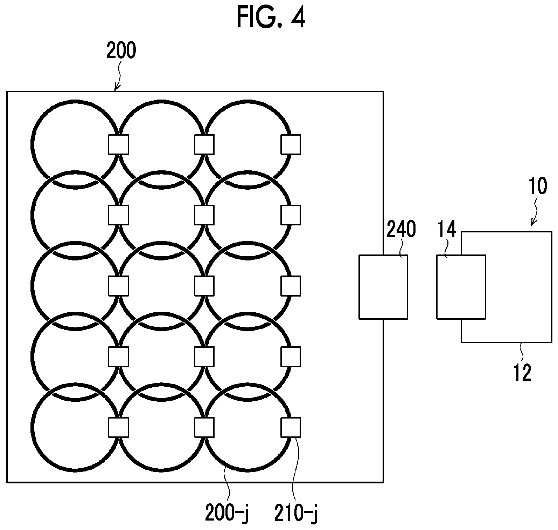

Fig. 4 is an explanatory diagram showing an application example of the optical wireless unit 10 according to the embodiment of the present disclosure. The receive coil unit 200 comprises a connector 240 for physical cable connection including a multi-channel signal line terminal for obtaining a signal from each of the plurality of coil elements 200-j, and can be connected to the optical wireless unit 10 in a cableless manner via the connector 240.

The optical wireless unit 10 is an optical wireless communication module that is covered with a cableless housing 12 and is connectable to a receive coil unit 200 via a connector 14 and a connector 240. The housing 12 is a shield housing that functions as an electromagnetic wave shield. The connector 240 is an example of a "first connector", and the connector 14 is an example of a "second connector".

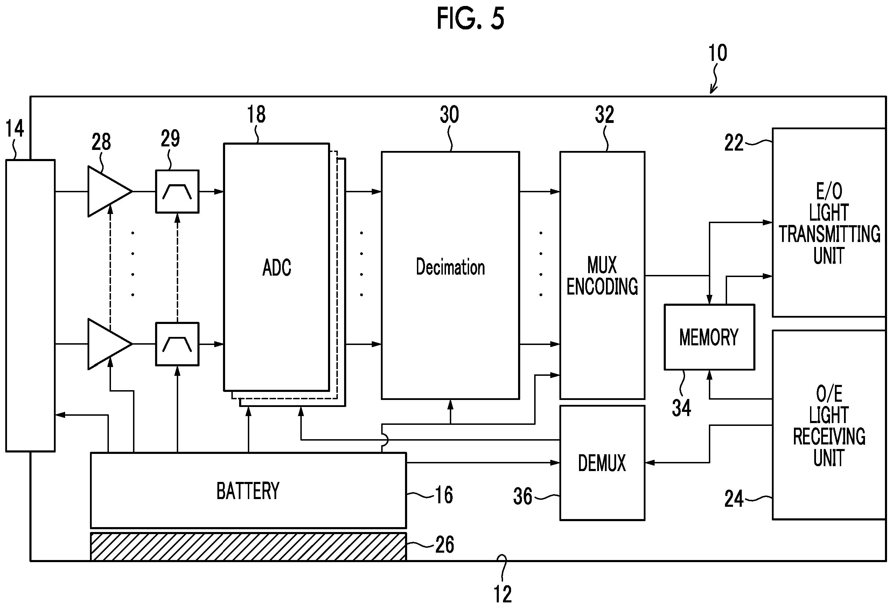

Fig. 5 is a block diagram showing a functional configuration of the optical wireless unit 10. In the housing 12, a battery 16, an analog to digital (A/D) converter 18, an electrical to optical (E/O) light transmitting unit 22, and an optical to electrical (O/E) light receiving unit 24 are housed in the optical wireless unit 10. The battery 16 supplies electricity for driving to the internal circuit of the optical wireless unit 10 itself and supplies electricity for a preamplifier of the receive coil unit 200 connected via the connector 14. The battery 16 is a rechargeable battery, and the optical wireless unit 10 comprises a charging port 26 for charging the battery 16.

The A/D converter 18 converts the analog signal received from the receive coil unit 200 through the connector 14 into digital signal data. The optical wireless unit 10 may include a variable gain amplifier 28 and a filter circuit 29 in front of the A/D converter 18.

The E/O light transmitting unit 22 is an optical wireless modulator that converts (E/O conversion) the signal data received from the receive coil unit 200 into an optical wireless signal and transmits the optical wireless signal. The O/E light receiving unit 24 is an optical wireless demodulator that receives a control signal transmitted by optical wireless and converts the control signal into an electrical signal by O/E conversion. The control signal received by the O/E light receiving unit 24 includes, for example, a control signal for controlling a conversion timing of the A/D converter 18, a control signal for a coil for controlling the receive coil unit 200, and the like.

The optical wireless unit 10 may further comprise a decimator 30 that thins out the digital signal data converted by the A/D converter 18 inside the housing 12. In addition, the optical wireless unit 10 may comprise a multiplexer that performs serialization (P/S conversion) for optical wireless transmission and a serializer 32 including an encoding function. The serializer 32 is an example of a "circuit that serializes".

The optical wireless unit 10 may comprise a memory 34 that can temporarily store data in preparation for a temporary communication failure. With the configuration comprising the memory 34, for example, the data subjected to the A/D conversion can be stored in the memory 34 in a case where temporary optical link failure (optical wireless communication failure) occurs, and can be transmitted after the optical link is reestablished.

Further, the optical wireless unit 10 may comprise a deserializer 36 that deserializes (serial to parallel conversion (S/P conversion)) the control signal received via the O/E light receiving unit 24. The deserializer 36 is an example of a "circuit that deserializes".

For example, in a case where the number of coil elements 200-j included in the receive coil unit 200 is 128 and signals of 128 channels (ch) are obtained from the receive coil unit 200, the A/D converter 18 includes a plurality of A/D converters that convert analog signals of each of 128 ch channels into digital signal data. The A/D converter 18 may be configured to convert the input analog signal into, for example, a 16-bit digital signal. The sampling rate of the A/D converter 18 may be, for example, 100 Msps (sample per second).

The decimator 30 decimates (down-samples) an output signal of the A/D converter 18, for example, to 1/20. The E/O light transmitting unit 22 and the O/E light receiving unit 24 may be, for example, an optical wireless transceiver that supports communication of 12.8 Gbps. The E/O light transmitting unit 22 and the O/E light receiving unit 24 are examples of an "optical transceiver".

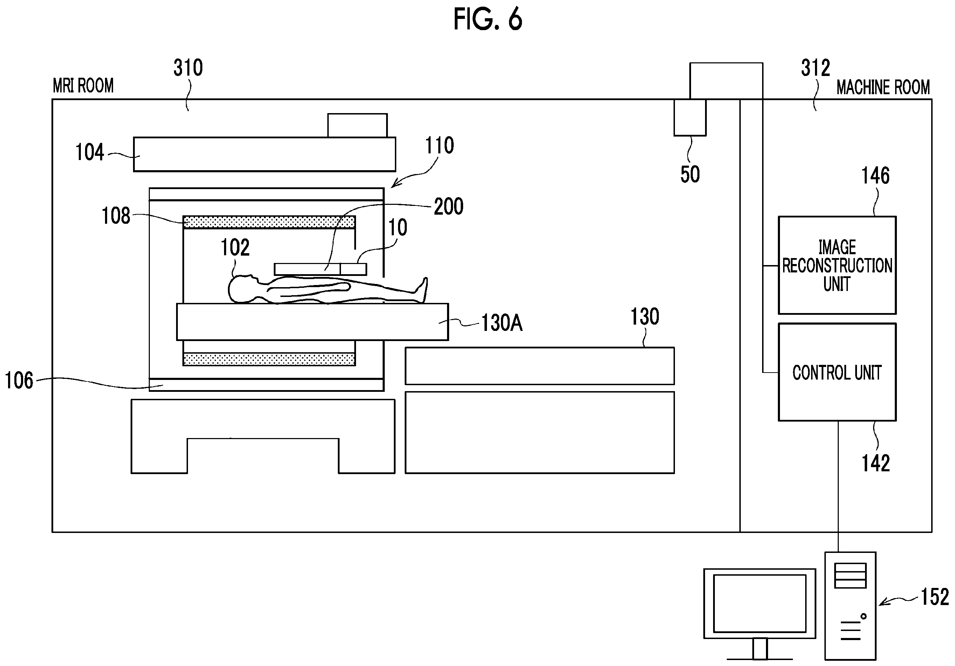

Fig. 6 is an explanatory diagram schematically showing a configuration of the MRI apparatus 100 using the optical wireless unit 10. The gantry 110 and the bed 130 are installed in a room of an MRI room 310, which is an examination room for the MRI examination. The optical wireless unit 10 connected to the receive coil unit 200 performs optical wireless communication with the optical wireless unit 50. The optical wireless unit 50 is disposed on a ceiling of the MRI room 310 or on a wall surface of the MRI room 310. The control unit 142 and the image reconstruction unit 146 of the MRI apparatus 100 are disposed in the machine room 312 and are connected to the optical wireless unit 50. The optical wireless unit 10 is an example of a "first optical wireless unit", and the optical wireless unit 50 is an example of a "second optical wireless unit".

The control unit 142 is connected to the console 152. The console 152 may include a computer that functions as the controller 140 and the operation unit 150 shown in Fig. 2.

### Overview of Operations of Optical Wireless Units 10 and 50

An overview of the operation of the MRI apparatus 100 using the optical wireless units 10 and 50 is as follows.

[Step 1] The optical wireless unit 10 charges the battery 16 in a case where the optical wireless unit 10 is not used.

[Step 2] The optical wireless unit 10 is connected to the receive coil unit 200.

[Step 3] The optical wireless unit 10 reads the coil information of the connected receive coil unit 200 and performs optical wireless connection with the optical wireless unit 50. The applied optical wireless communication technology may be, for example, light fidelity (LiFi). LiFi is a technology that realizes wireless bidirectional communication by modulating light at a high speed. LiFi can also support optical communication using not only visible light but also near-infrared light, and can avoid the influence of electromagnetic wave interference as compared with wireless communication using radio waves, and can perform high-speed and stable communication.

[Step 4] A control signal is output from the control unit 142 in accordance with the parameter of the receive coil unit 200 input or selected by the console 152.

[Step 5] The control signal output from the control unit 142 is transmitted by optical wireless transmission to the optical wireless unit 10 via the optical wireless unit 50.

[Step 6] The optical wireless unit 10 receives the control signal by the O/E light receiving unit 24, O/E converts the received control signal to operate the device such as the A/D converter 18 in accordance with the control signal, and digitizes the reception signal from the receive coil unit 200.

[Step 7] The optical wireless unit 10 thins out the signal digitized by the A/D converter 18 into a format that can be transmitted by optical wireless transmission by the decimator 30, and performs encoding processing by the serializer 32.

[Step 8] The optical wireless unit 10 performs E/O conversion of the digital signal encoded by the serializer 32 by the E/O light transmitting unit 22 and transmits the digital signal to the optical wireless unit 50 by optical wireless.

[Step 9] The optical wireless unit 50 performs O/E conversion on the optical wireless signal received from the optical wireless unit 10 and transmits the optical wireless signal to the image reconstruction unit 146 from the optical wireless unit 50.

[Step 10] The image reconstruction unit 146 performs processing of reconstructing the image from the data of the NMR signal acquired via the optical wireless unit 50, and provides the image to the console 152. In this way, the MRI image, which is the reconstructed image, is displayed on the display device of the console 152.

### Example of Signal Received by O/E Light Receiving Unit 24

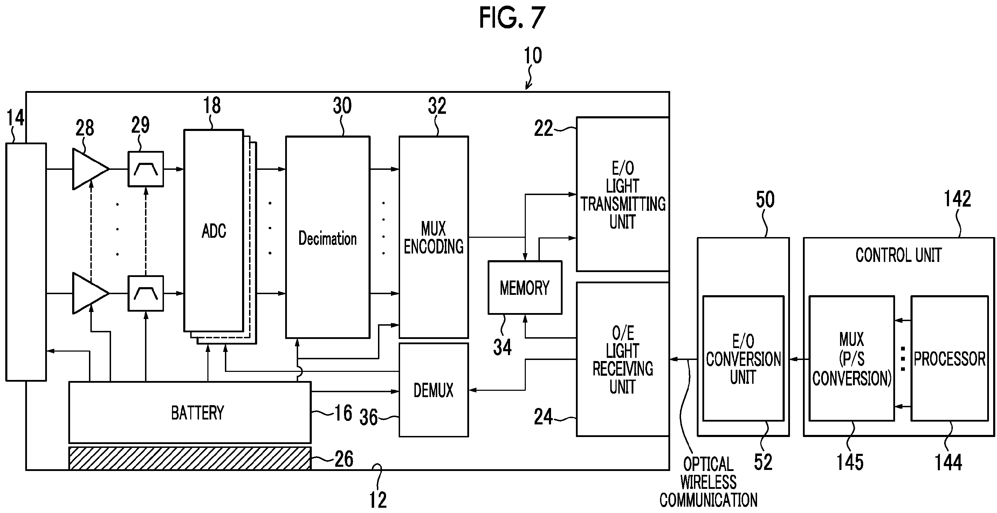

Fig. 7 is an explanatory diagram of a case where a control signal is transmitted from the control unit 142 to the optical wireless unit 10 via the optical wireless unit 50.

The control unit 142 includes a processor 144 that generates a control signal and a multiplexer 145. The processor 144 may be configured using, for example, a field programmable gate array (FPGA). The processor 144 is not limited to the FPGA and may be configured by another programmable integrated circuit (IC) or digital signal processor (DSP) or a combination thereof.

The multiplexer 145 functions as a P/S conversion unit that converts parallel signals into serial signals.

The optical wireless unit 50 includes an E/O conversion unit 52, performs E/O conversion of the serial signal output from the control unit 142, and transmits the serial signal in a form of an optical signal of optical wireless communication.

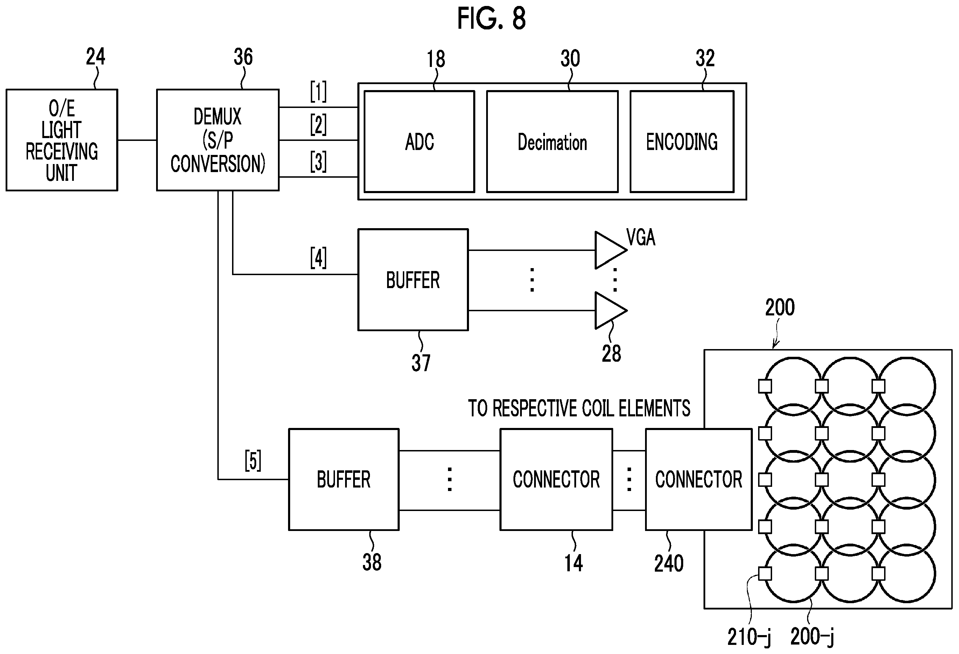

Fig. 8 is an explanatory diagram illustrating a specific example of a signal received by the optical wireless unit 10 through optical wireless communication. In the O/E light receiving unit 24, for example, the signals shown in [1] to [5] below are serialized and transmitted, and are restored (S/P conversion) by the deserializer 36 and then transmitted to each control destination. Signal lines of reference numerals [1] to [5] in the drawing each represent transmission lines of signals shown below.
[1] Sampling clock for A/D converter 18 synchronized with RF irradiation signal
[2] Control signal for operating setting of A/D converter 18
[3] Control signal for setting of digital signal processing including decimation and encoding
[4] Control signal for gain setting of variable gain amplifier (VGA) 28
[5] Decoupler signal of receive coil unit 200

The control signal for gain setting of VGA 28 is distributed to each VGA 28 via the buffer 37 after being restored by the deserializer 36. In addition, the decoupler signal of the receive coil unit 200 is restored by the deserializer 36 and then distributed by the fan-out buffer 38 to perform the decoupling control of each coil element 200-j.

### Configuration Example of Housing 12

The optical wireless unit 10 comprises a housing 12 having a shielding (electromagnetic shielding) effect in order to avoid the influence of the RF pulse and the gradient magnetic field coil (GC) pulse in the use environment of the MRI apparatus 100, and an internal circuit such as an A/D converter 18 and a digital processing circuit is disposed in the housing 12. The digital processing circuit includes a circuit that executes processing such as decimation, encoding, P/S conversion (serialization), and S/P conversion (deserialization).

The housing 12 may be configured by using, for example, a substrate material made of a thin metal foil. As a more specific example, the housing 12 may be formed of a metal material having a thickness of several tens of micrometers, such as a substrate material. In addition, by providing slits that compartmentalize the metal material forming the housing 12 into a plurality of regions and limiting the area of the region of the metal material compartmentalized by the slits (the continuous conductor region which is the solid region between the slits), the occurrence of eddy currents due to the RF pulses or the GC pulses is suppressed. For example, in a case of an MRI apparatus of 1.5 T (tesla), the generation of overcurrent is suppressed and the influence on the MRI image is reduced by providing the slit and limiting the area of the region of the metal material compartmentalized by the slit to about 80 cm² (square centimeters).

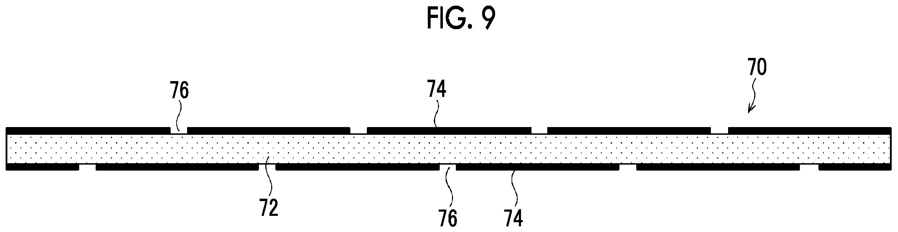

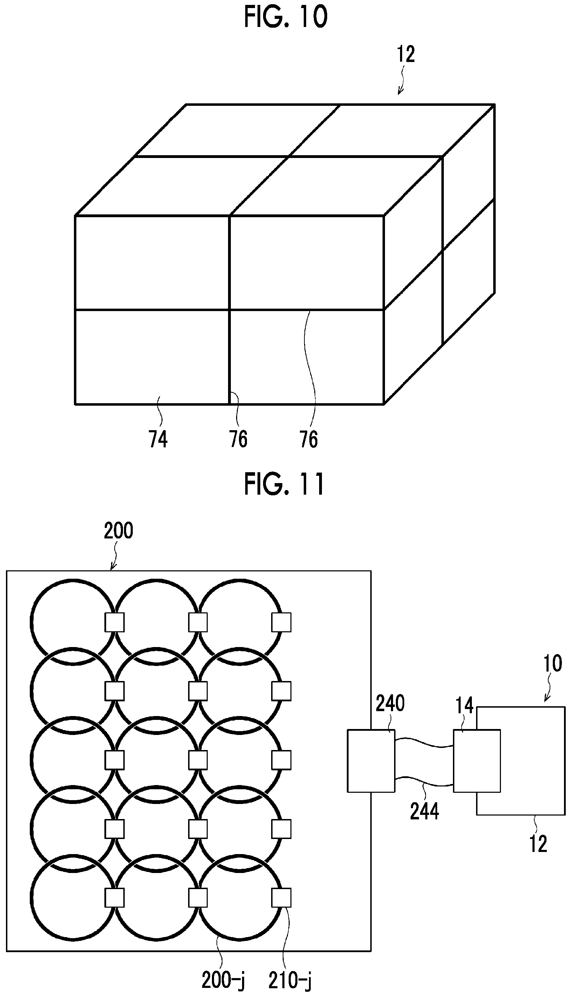

Fig. 9 is a cross-sectional view showing an example of a substrate material 70 used in the housing 12, and Fig. 10 is a perspective view showing an example of the housing 12 configured using the substrate material 70. Fig. 10 shows an example in which a metal material 74 forming the housing 12 is compartmentalized by a slit 76. The portion of the edge side of the rectangular parallelepiped shown in Fig. 10 does not need to be continuously covered with the metal material 74, and the metal material 74 may be interrupted at the portion of the edge side. The edge portion can be a boundary that defines a compartment (closed region) of the metal material 74, similarly to the slit 76. That is, the contact portion between the substrate materials 70 may be insulated for the purpose of limiting the continuous conductor area. The regions of the metal material 74 of the adjacent compartments through the edge portion or the slit 76 are discontinuous conductor regions.

The substrate material 70 may be a double-sided substrate material in which a metal material 74 such as a copper foil is laminated on a substrateformed of a low-conductivity material 72 such as a glass epoxy resin (see Fig. 9). The low-conductivity material 72 may be an insulator. The thickness of the low-conductivity material 72 may be, for example, about 1 millimeter (mm).

The substrate material 70 comprises a slit 76 for limiting the area of the closed region of the metal material 74. In a case of a double-sided substrate material as shown in Fig. 9, the metal material 74 is configured as a two-layer structure in which the low-conductivity material 72 is interposed, and metal layers (layers of the metal material 74) are disposed on both surfaces of the low-conductivity material 72. Therefore, in a case where the substrate material 70 is viewed in a plan view, it is preferable that the positions of the slits 76 in the first direction (for example, the vertical direction) provided on the front and back metal layers are relatively shifted in the second direction (for example, the horizontal direction) different from the first direction. As described above, in the plan view, the positions of the slits 76 are relatively shifted between the front and back metal layers, and the slits 76 do not overlap each other between the front and back metal layers, whereby the shielding effect can be enhanced while suppressing the occurrence of eddy current. Further, the layer structure and the slit structure of the metal material 74 also have an effect of preventing noise components generated from the circuit (internal circuit) in the housing 12 from appearing in the MRI image.

In Fig. 9, the layer of the metal material 74 disposed on the first surface, which is the upper surface of the low-conductivity material 72, is an example of a "first metal layer", and the layer of the metal material 74 disposed on the second surface, which is the lower surface of the low-conductivity material 72, is an example of a "second metal layer".

Example in which Optical Wireless Unit 10 and Receive coil Unit 200 are Connected to Each Other Using Cable

Fig. 11 is a diagram showing an example of a case where the optical wireless unit 10 and the receive coil unit 200 are connected to each other by using a flexible cable 244.

The connection between the optical wireless unit 10 and the receive coil unit 200 is not limited to a form in which the connectors 14 and 240 are directly connected to each other, and for example, the connection can be made by using a cable 244. In the medical field, it is preferable that a cable 244 that can be connected to the connector 14 of the optical wireless unit 10 and the connector 240 of the receive coil unit 200 is separately prepared so that either the connector connection or the cable connection can be selected. A connector (not shown) that can be connected to the connectors 14 and 240 is provided at both ends of the cable 244. The length of the cable 244 can be designed to an appropriate length as necessary.

For example, in a case where the receive coil unit 200 is soft and is of a type that is wound around the subject 102, the optical wireless unit 10 that is directly connected to the connector 240 of the receive coil unit 200 may be in the way. In a case where it is difficult to directly connect the optical wireless unit 10 to the receive coil unit 200, the degree of freedom of the disposition place of the optical wireless unit 10 can be increased by connecting the optical wireless unit 10 to the receive coil unit 200 using the cable 244.

### Effects of Embodiment

With the optical wireless unit 10 according to the embodiment, the following effects can be obtained.
(1) It is possible to provide an easy-to-use optical wireless unit 10 comprising a cableless housing 12 that can be attachably and detachably connected to the connector 240 of the receive coil unit 200.
(2) The optical wireless unit 10 can avoid electromagnetic wave interference and transmit data of the NMR signal.
(3) Since the housing 12 of the optical wireless unit 10 is a shield housing and the area of the region of the metal material 74 of each compartment compartmentalized by the slit 76 is limited, the generation of eddy current due to the RF transmission pulse or the GC pulse can be suppressed, and the influence of the noise component on the MRI image can be reduced.
(4) The structure in which the positions of the slits 76 are relatively shifted on the front and back surfaces of the substrate material 70 which is a double-sided substrate material makes it possible to increase the shielding effect while suppressing the occurrence of eddy currents, and to obtain an MRI image in which the influence of noise components is suppressed.
(5) The optical wireless unit 10 can store data in the memory 34 in a case where a communication failure (optical link failure) occurs in the optical wireless communication between the optical wireless unit 10 and the optical wireless unit 50, and can transmit the data in the memory 34 after the optical wireless communication is reestablished, by comprising the memory 34 that temporarily stores the A/D converted data.

### Others

The present disclosure is not limited to the above-mentioned embodiment, and various modifications are possible within the scope of the technical concept of the present disclosure without departing from its scope as defined by the claims.

### Explanation of References

10: optical wireless unit
12: housing
14: connector
16: battery
18: A/D converter
22: E/O light transmitting unit
24: O/E light receiving unit
26: charging port
28: variable gain amplifier
29: filter circuit
30: decimator
32: serializer
34: memory
36: deserializer
37: buffer
38 fan-out buffer
50: optical wireless unit
52: E/O conversion unit
70: substrate material
72: low-conductivity material
74: metal material
76: slit
100: MRI apparatus
102: subject
104: static magnetic field generating magnet
106: gradient magnetic field coil
108: RF transmission coil
110: gantry
112: high-frequency magnetic field generator
114: receiver
116: gradient magnetic field power supply
118: sequencer
120: bore
130: bed
130A: top plate
140: controller
142: control unit
144: processor
145: multiplexer
146: image reconstruction unit
150: operation unit
152: console
200: receive coil unit
200-1, 200-2, 200-3, 200-4, 200-j: coil element
202: decoupling power supply
210-1, 210-2, 210-3, 210-4, 210-j: decoupling circuit
240: connector
244: cable
310: MRI room
312: machine room

## Claims

1. An optical wireless unit that is connected to a receive coil unit (200) including a plurality of coil elements (200-j) via a connector (14), the optical wireless unit comprising:
a cableless housing (12),
wherein the housing includes
a battery (16) that supplies electricity to the receive coil unit, and
an optical transceiver (114) that converts signal data received from the receive coil unit into an optical wireless signal and transmits the optical wireless signal, and that receives and converts a control signal transmitted by the optical wireless transmission into an electrical signal.

2. The optical wireless unit according to claim 1,
wherein the connector (14) provided in the receive coil unit (200) is a first connector to which a physical cable (244) is connectable, and
the housing includes a second connector that is connectable to the first connector provided in the receive coil unit.

3. The optical wireless unit according to claim 1 or 2,
wherein the housing is a shield housing.

4. The optical wireless unit according to claim 3,
wherein the housing is configured using a substrate material (70) including a layer (74) of a metal material.

5. The optical wireless unit according to claim 4,
wherein the substrate material is a double-sided substrate material in which the layer of the metal material is laminated on both surfaces of a low-conductivity material.

6. The optical wireless unit according to any one of claims 3 to 5,
wherein the housing includes a slit (76) that compartmentalizes the metal material forming the housing, and
an area of a continuous conductor region of the metal material compartmentalized by the slit is limited.

7. The optical wireless unit according to claim 6,
wherein the metal material forming the housing includes a first metal layer and a second metal layer that are laminated with a low-conductivity material (72) interposed therebetween,
the first metal layer and the second metal layer each include the slit, and
in a case where the metal material is viewed in a plan view, positions of the slits in a first direction provided in each of the first metal layer and the second metal layer are relatively shifted in a second direction different from the first direction.

8. The optical wireless unit according to any one of claims 1 to 7,
wherein the housing further includes a memory (34) that temporarily stores the signal data.

9. The optical wireless unit according to any one of claims 1 to 8,
wherein the housing further includes an A/D converter (18) that converts an analog signal received from the receive coil unit into a digital signal.

10. The optical wireless unit according to claim 9,
wherein the housing further includes a digital processing circuit that processes the digital signal, and
preferably, the digital processing circuit includes a decimator that thins out data of the digital signal.

11. The optical wireless unit according to claim 10,
wherein the digital processing circuit includes a circuit that serializes the signal data obtained from each of the plurality of coil elements for optical wireless transmission, and
preferably, the circuit to be serialized includes a multiplexer and a circuit for encoding.

12. The optical wireless unit according to any one of claims 1 to 11,
wherein the housing further includes a circuit (36) that deserializes the control signal.

13. The optical wireless unit according to any one of claims 1 to 12,
wherein the control signal includes at least one of a sampling clock of an A/D converter disposed in the housing, a control signal for operating setting of the A/D converter, a control signal for setting of digital signal processing, a control signal for gain setting of a variable gain amplifier, or a decoupler signal of the receive coil unit.

14. The optical wireless unit according to any one of claims 1 to 13,
wherein the housing further includes a charging port (26) for charging the battery.

15. A magnetic resonance imaging apparatus comprising:
a receive coil unit (200) that includes a plurality of coil elements (200-j) and includes a connector (14) to which a physical cable (244) for transmitting a nuclear magnetic resonance signal obtained from the plurality of coil elements is connectable;
the optical wireless unit according to any one of claims 1 to 14, the optical wireless unit being connected to the receive coil unit via the connector;
another optical wireless unit that performs optical wireless communication with the optical wireless unit; and
an image reconstruction unit that reconstructs an image on the basis of data of the nuclear magnetic resonance signal acquired via the another optical wireless unit.
